# EUROPÄISCHE PATENTSCHRIFT

(11) **EP 2 182 379 B1**
(45) Veröffentlichungstag und Bekanntmachung des Hinweises auf die Patenterteilung: **19.09.2012**
(21) Anmeldenummer: 08105703.6
(22) Anmeldetag: 30.10.2008
(51) Int. Cl.: G01S 7/489, H03G 3/30

(54) **Entfernungsmessender Laserscanner**
Laser scanner to measure distance
Scanner laser mesurant l'éloignement

(43) Veröffentlichungstag der Anmeldung: 05.05.2010
(73) Patentinhaber: SICK AG, 79183 Waldkirch (DE)
(72) Erfinder: Pastor, Sebastian, 79104 Freiburg (DE); Themel, Helmut, 79183 Waldkirch (DE)
(74) Vertreter: Hehl, Ulrich

(56) Entgegenhaltungen:
- EP-A- 0 782 007
- EP-A- 0 848 495
- EP-A- 1 795 913
- WO-A1-2009/039875
- US-B1- 6 439 460

## Beschreibung

Die Erfindung betrifft einen entfernungsmessenden Laserscanner sowie ein Verfahren zur Erfassung von Entfernungen mittels eines Laserscanners mit einer steuerbaren Verstärkung des Empfangssignals nach dem Oberbegriff von Anspruch 1 beziehungsweise 8.

Laserscanner können eingesetzt werden, um Abstände oder Entfernungen in einem Überwachungsbereich zu bestimmen. Dazu wird die Lichtlaufzeit zwischen Aussenden und Empfang eines Lichtsignals ausgewertet, das von einer Oberfläche in dem Überwachungsbereich remittiert oder reflektiert wird.

Man unterscheidet zwei Verfahren, nämlich Pulslaufzeitverfahren und Phasenverfahren. In Pulslaufzeitverfahren werden einzelne kurze Lichtpulse ausgesandt und deren Laufzeit anhand eines Charakteristikums des Pulses, beispielsweise dessen Maximum bestimmt. Bei einem Phasenverfahren wird das Licht amplitudenmoduliert und die Phasenverschiebung des ausgesandten gegenüber dem empfangenen Licht ausgewertet. Phasenverfahren haben zunächst einen durch die verwandte Modulationsfrequenz des Lichts begrenzten Eindeutigkeitsbereich, der aber durch zusätzliche Maßnahmen erweitert werden kann. Mit beiden Verfahren erhält man jeweils den Abstandswert zu dem aktuellen Scanpunkt.

Mit Hilfe einer Scanbewegung, die häufig über bewegliche Ablenkelemente, beispielsweise einen Drehspiegel realisiert wird, können Scanlinien und damit Abstandsprofile ermittelt werden. Ist auch noch eine Bewegung in der Querrichtung zu der Scanlinie vorgesehen, etwa durch einen weiteren Ablenkmechanismus oder eine Relativbewegung durch Anbringung des Scanners an einem Fahrzeug oder über einem Förderband oder einer Straße, so können dreidimensionale Höhenkarten aufgezeichnet werden.

Der Dynamikbereich der Empfangssignalleistung, in dem ein Laserscanner arbeitet, ist sehr hoch. Eine Ursache dafür bilden unterschiedliche Oberflächeneigenschaften und damit unterschiedliches Remissionsverhalten, welches zwischen Extremen wie schwarzer Samt einerseits und einem Reflektor andererseits schwanken kann. Eine weitere Ursache liegt in dem quadratischen Empfangssignalverlust mit dem Abstand, welcher sich beispielsweise an Objektkanten sehr abrupt ändern kann. Das Empfangssystem des Laserscanners muss so ausgelegt sein, dass eine Auswertung des Empfangssignals über diesen gesamten Dynamikbereich erfolgen kann.

Herkömmlich wird häufig im Anschluss an den Lichtempfänger ein Transimpedanzverstärker eingesetzt, der für große Empfangssignale übersteuert betrieben wird. Damit stehen aber folgenden Auswertestufen die aufgrund der Übersteuerung verlorenen Signalinformationen nicht mehr zur Verfügung, und dieser Verlust hat einen erhöhten Messfehler zur Folge. Zudem ist die Signalform stark verzerrt und erschwert die Auswertung oder macht sie unmöglich. Dies gilt besonders bei Pulsverfahren, wenn Empfangspulse etwa infolge eines Kantentreffers sehr dicht aufeinanderfolgen. Das umgekehrte Vorgehen, eine Übersteuerung durch Anpassung des Dynamikbereichs auf starke Empfangssignale zu vermeiden, führt zu einer schlechten Erkennung von schwachen Empfangssignalen und bringt daher noch schwerwiegendere Nachteile mit sich.

Es ist auch bekannt, in entfernungsmessenden Lasersystemen Stellglieder zur Dämpfung oder Verstärkung des Empfangssignals einzusetzen. Diese sind aber für scannende Entfernungsmesser nicht geeignet, weil die notwendige Amplitudeninformation jeweils zu spät verfügbar ist. Zwar kann die Verstärkung an die Empfangsstärke eines früheren Messpunkts eingestellt werden. Erhält der so eingestellte Verstärker aber das nächste Messsignal, das aufgrund der Scanbewegung von einem anderen Punkt im Überwachungsbereich remittiert wurde, so kann eine Kante oder ein Farbwechsel den lediglich auf einen benachbarten Punkt im Überwachungsbereich eingestellten Verstärker übersteuern oder ein nicht mehr auflösbar schwaches Empfangssignal liefern. Insgesamt ist durch die Stellglieder keineswegs sichergestellt, dass die Verstärkung besser passt als eine beliebige Voreinstellung. Dies gilt vor allem für kontraststarke, abwechslungsreiche Umgebungen und schnelle Scan- oder Relativbewegungen.

Es ist im Stand der Technik, etwa aus der EP 1 936 400 A1, auch bekannt, einen Vorpuls auszusenden, um vor der eigentlichen Entfernungsmessung eine Information über die Empfangsstärke zu erhalten und die Sendestärke daran anzupassen. Diese leidet aber an denselben Nachteilen wie eine Anpassung der Verstärkung an frühere Messsignale, dass nämlich Vorpuls und Messpuls nicht dieselbe Stelle im Überwachungsbereich treffen, was zu Amplitudenunterschieden führen kann. Außerdem wird hiermit für einen Empfangspuls, der mehrere Maxima oder Peaks aufweist, nur ein gemeinsamer Verstärkungsfaktor eingestellt, der bestenfalls auf einen Peak gut passt und die anderen nur schwach verstärkt oder übersteuert.

Aus der EP 1 795 913 A2 ist ein Laserscanner bekannt, der aus der Laufzeit zwischen Aussenden und Empfang eines Lichtsignals die Entfernung zu einem Objekt bestimmt. Dem Lichtempfangselement ist ein Hilfsempfangselement unter Berücksichtigung der Scanbewegung derart zugeordnet, dass das Hilfsempfangselement jeweils Lichtanteile jeweils kurz vor dem eigentlichen Lichtempfangselement empfängt. Die Information des Hilfsempfangselements wird genutzt, um die Verstärkung für das eigentliche Lichtempfangselement zu steuern.

Die EP 0 848 495 A2 zeigt eine Signalverstärkungsschaltung für den Empfangsteil eines optischen Kommunikationssystems. Um die schwachen eingehenden Signale auflösen zu können, werden eine untere Grenze und eine obere Grenze der Eingangssignale ermittelt und diese Werte für die Steuerung eines Verstärkers verwendet.

Aus der US 6 439 460 B1 ist ein Barcodeleser mit einem steuerbaren Verstärker und einer Sofortverstärkung bekannt. In einer zweiten aus insgesamt drei Verstärkerstufen wird das Eingangssignal auf zwei parallelen Zweigen einerseits zur Einstellung eines Verstärkungsfaktors ausgewertet und parallel dazu in einem Puffer verzögert, bis diese Einstellung erfolgt ist.

Die EP 0 782 007 A2 zeigt einen Entfernungsmesser mit einer Scanspiegelanordnung und einem steuerbaren Verstärker für das Empfangssignal. Die Regelung des Verstärkers erfolgt dabei anhand der Amplitude des ausgewerteten, also bereits verstärkten Signals.

Aus der nachveröffentlichten WO 2009/039875 A1 ist eine laserbasierte distanzmessende Vorrichtung bekannt, die einen Aktor aufweist, um eine Optikeinheit mit Sender und Empfänger zu rotieren. Das Empfangssignal wird in einem Zweig hinsichtlich seiner Amplitude ausgewertet und in einem anderen Zweig so lange verzögert, bis anhand der bestimmten Amplitude ein steuerbarer Verstärker angepasst ist.

Es ist daher Aufgabe der Erfindung, einen entfernungsmessenden Laserscanner anzugeben, der mit unterschiedlichsten Umgebungen und der daraus resultierenden Empfangssignaldynamik umgehen kann.

Diese Aufgabe wird durch einen entfernungsmessenden Laserscanner mit steuerbarem Verstärker nach Anspruch 1 und ein Verfahren zur Erfassung von Entfernungen mittels eines Laserscanners und einer Steuerung der Verstärkung gemäß Anspruch 8 gelöst.

Die erfindungsgemäße Lösung geht von dem Prinzip aus, den Empfangskanal ohne Signalinformationsverlust auszuwerten. Es wird also dafür gesorgt, dass jedes Empfangssignal in einem informationsverlustfreien, insbesondere linearen Bereich verstärkt werden kann. Dazu wird die Verstärkung nachgesteuert, und zwar auf Basis der tatsächlichen Empfangssignalstärke an dem Scanwinkel selbst. Dazu wird das Empfangssignal selbst hinsichtlich seiner Amplitude ausgewertet, und diese Information wird zur Steuerung des Verstärkers genutzt. Diese Information steht also rechtzeitig zur Verfügung, um ein beispielsweise elektrisches Stellglied des Verstärkers entsprechend setzen zu können. Die Amplitude des Empfangssignals wird schnell ausgewertet und an das Stellglied weitergeleitet, so dass eine Verstärkungsanpassung noch für dasselbe Empfangssignal erfolgen kann.

Besonders vorteilhaft erweist sich dieses Vorgehen bei einem pulsbasierten Laserscanner, der also als Signal Pulse verwendet, somit Lichtpulse aussendet und einen oder mehrere aus diesem Sendepuls resultierende Empfangspulse auswertet. Phasenbasierte Laserscanner können wegen des dauerhaft ausgesandten modulierten Lichts leichter dynamisch nachgesteuert werden. Besonders bei hochvariabler Umgebung beziehungsweise schnellen Bewegungen zeigt die Erfindung aber auch für phasenbasierte Entfernungsmessung Vorteile, weil sich die Empfangssignalstärke sehr rasch ändern kann und die herkömmliche Nachsteuerung auch bei moduliertem cw-Licht zu langsam ist.

Die Erfindung hat den Vorteil, dass der Signalempfangspfad mit einer Verstärkung ohne Informationsverlust und in der Praxis bevorzugt linear arbeiten kann. Daraus resultiert eine höhere Messgenauigkeit und eine verbesserte Auswertung der Signalform, beispielsweise von eng aufeinanderfolgenden Pulsen wie im Falle von Kantentreffen. Ein Vorpuls oder ähnliche Zusatzmaßnahmen sind nicht erforderlich.

Herkömmlich wird bei pulsbasierten Verfahren häufig nur ein Empfangspuls erwartet und ausgewertet. Erfindungsgemäß ist darüber hinaus vorgesehen, auch mehrfache Empfangspulse auszuwerten, die aus demselben Sendepuls resultieren. Derartige Mehrfachpulse können beispielsweise entstehen, wenn das Laserlicht zunächst durch Hindernisse wie Nebel, Regentropfen oder Glasflächen hindurchtreten muss, ehe es auf die eigentlich auszuwertende Objektoberfläche trifft. Mehrfachpulse können beispielsweise durch Aufzeichnung des Empfangssignals in einem Analog/Digital-Konverter ausgewertet werden. Erfindungsgemäß ist möglich, jeden einzelnen der mehrfachen Empfangspulse optimal zu verstärken, damit das gesampelte Empfangssignal als die Grundlage der Auswertung mit hoher Präzision aufzuzeichnen und so die Messgenauigkeit erheblich zu vergrößern. Es kann also jeder einzelne Peak des Empfangssignals optimal verstärkt und damit in seiner Lage besonders genau bestimmt werden.

Das Lichtempfangselement ist bevorzugt über ein Verzögerungselement mit dem Verstärker verbunden, wobei die Verbindung mit dem Verzögerungselement dafür ausgebildet ist, das Empfangssignal so weit verzögert dem Verstärker zuzuführen, dass der Verstärker aufgrund der Amplitudeninformation nachgesteuert ist, ehe das Empfangssignal den Verstärker erreicht. Das Empfangssignal erreicht den Verstärker also gezielt erst dann, wenn dieser richtig nachgesteuert ist. Aufgrund schneller elektronischer Bausteine zur Bestimmung der Amplitudeninformation ist nur eine minimale Verzögerungszeit erforderlich. Diese Verzögerungszeit spielt aber auch praktisch kaum eine Rolle, da ja der Empfang der weiteren Signale nicht blockiert ist und der Ablauf des Laserscanners ohne Beeinträchtigung fortgesetzt werden kann. Allenfalls ergibt sich ein einmaliges Offset der Ausgabe der Abstandsdaten durch den Laserscanner, nämlich in der Größenordnung der einmaligen Verarbeitungszeit des Amplituden-Bestimmungselements, die aber im Betrieb unmerklich ist. Die Schaltung kann demnach nach allen praktischen Maßstäben in Echtzeit auswerten und dazu eine geeignete oder, je nach Verfahren, sogar die optimale Amplitudeninformation für die Verstärkung verwenden.

Das Verzögerungselement ist besonders bevorzugt als Verzögerungsleitung ausgebildet, deren Länge auf die Verarbeitungszeit des Amplituden-Bestimmungselements und/oder die Verarbeitungszeit für die Steuerung des Verstärkers abgestimmt ist. Dies ist eine besonders einfache und kostengünstige Lösung, welche das Empfangssignal verzerrungsfrei verzögert.

Das Amplituden-Bestimmungselement bestimmt die Amplitudeninformation bevorzugt anhand einer oder mehrerer Schwellen, oder das Amplituden-Bestimmungselement ist ein Peakdetektor. Schwellenbestimmungen sind einfach zu realisieren und ermöglichen beispielsweise, die Verstärkung in den Schwellen entsprechenden Klassen zu wählen, etwa eine schwache, mittlere und große Verstärkung. Alternativ kann mit einem Peakdetektor direkt der maximale Amplitudenwert bestimmt werden, und der Verstärker kann mit einem optimalen Verstärkungswert gesteuert werden, so dass der lineare Bereich des Verstärkers vollständig genutzt wird. Da man die Pulsform im Grund kennt, kann man anstelle des Peaks auch andere Charakteristika bewerten, beispielsweise das Anstiegsverhalten.

Das Amplituden-Bestimmungselement ist bevorzugt mit einem Stellglied des Verstärkers verbunden und kann eine Steuerspannung, einen Steuerstrom oder einen digitalen Verstärkungsfaktor an das Stellglied übertragen. Somit entsteht eine einfache Steuerung, die jeweils für die richtige Verstärkung sorgt.

Das Amplituden-Bestimmungselement weist vorteilhafterweise einen Reseteingang auf, wobei insbesondere die Auswertungseinheit oder eine Teilkomponente des Amplituden-Bestimmungselements dafür ausgebildet ist, das Amplituden-Bestimmungselement über den Reseteingang zurückzusetzen. Dieser Reset kann beispielsweise zwischen zwei Peaks oder zwischen zwei Empfangspulsen ausgelöst werden, um die Amplitudeninformation zu löschen. Das eignet sich besonders im Falle eines Peakdetektors, damit nicht die Maximalamplitude eines früheren Empfangssignals oder Empfangspulses nachwirken kann.

Das Amplituden-Bestimmungselement weist bevorzugt eine Kennlinie auf, welche eine hohe Dynamik abbilden kann, insbesondere eine logarithmische Kennlinie, und die Kennlinie des Stellglieds ist bevorzugt so abgestimmt, dass Empfangssignale beliebiger Eingangsstärke von dem Verstärker auf verstärkte Empfangssignale zumindest annähernd gleicher Peakamplitude abgebildet werden. Das Amplituden-Bestimmungselement sollte mit der hohen Eingangssignaldynamik umgehen können, da ansonsten aufgrund unzureichender Amplitudeninformationen wiederum Bereiche entstehen würden, in denen der Verstärker übersteuert oder zu schwach verstärkt. Das Stellglied wird bevorzugt so gesteuert, dass immer derselbe, möglichst gesamte lineare Bereich des Verstärkers ausgenutzt wird. Damit kann die Lage der Empfangssignale verlässlich und unabhängig von den Remissionseigenschaften des jeweiligen Scanpunkts bestimmt und somit eine hohe Messgenauigkeit erreicht werden. Der Verstärker selbst sollte bevorzugt eine lineare Kennlinie aufweisen, um die Empfangssignale unverzerrt auswerten zu können.

Das erfindungsgemäße Verfahren kann auf ähnliche Weise durch weitere Merkmale ausgestaltet werden und zeigt dabei ähnliche Vorteile. Derartige weitere Merkmale sind beispielhaft, aber nicht abschließend, in den sich an den Vorrichtungsanspruch anschließenden Unteransprüchen beschrieben.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Fig. 1: eine stark schematisierte Ansicht der Arbeitsweise eines entfernungsmessenden Laserscanners und seines beispielhaften Sende- und Empfangssignals;
- Fig. 2: ein Blockschaltbild einer Ausführungsform des Empfangspfads eines erfindungsgemäßen entfernungsmessenden Laserscanners;
- Fig. 3A: ein beispielhafter empfangener schwacher Photostrom von 0,1 µA nach einem Lichtempfangselement an Position A des Laserscanners gemäß Figur 2;
- Fig. 3B: eine Ausgangsspannung an einem Peakdetektor an Position B des Laserscanners gemäß Figur 2 bei Anliegen des Photostroms gemäß Figur 3A;
- Fig. 3C: ein verzögerter Photostrom nach einer Verzögerungsleitung an Position C des Laserscanners gemäß Figur 2 bei Anliegen des Photostroms gemäß Figur 3A;
- Fig. 3D: ein Ausgangsstrom eines variablen Verstärkers an Position D des Laserscanners gemäß Figur 2 bei Anliegen der Ausgangsspannung gemäß Figur 3B an einem Stellglied und des zu verstärkenden verzögerten Photostroms gemäß Figur 3C;
- Fig. 4A-D: Darstellungen gemäß Figur 3A-D mit einem stärkeren Photostrom von 0,5 µA; und
- Fig. 5: eine Kennlinie Verstärkungsfaktor über Steuerspannung des spannungsgesteuerten Verstärkers gemäß Figur 2.

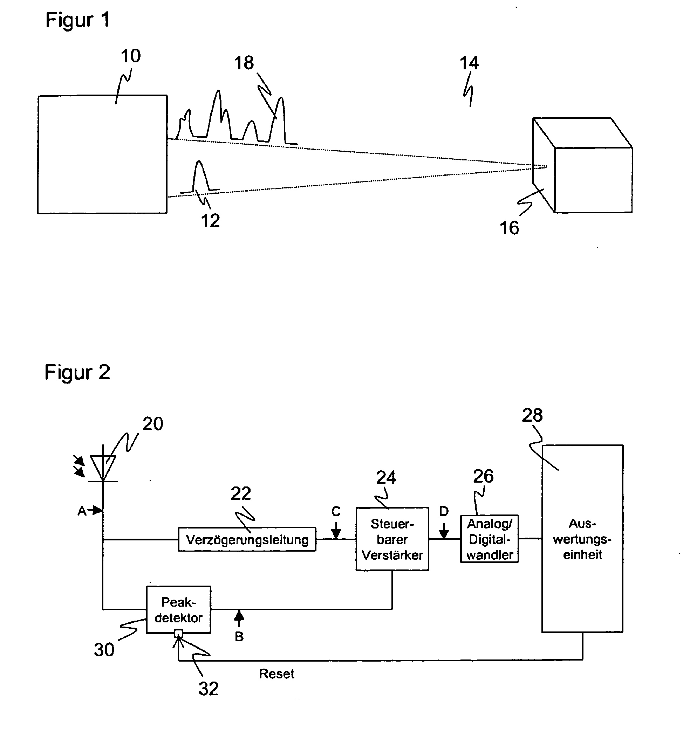

Figur 1 zeigt in sehr schematischer Vereinfachung einen Laserscanner 10, welcher mit einer Laserlichtquelle einen Lichtpuls 12 in einen Überwachungsbereich 14 aussendet. Der Lichtpuls 12 wird an einer Oberfläche 16 in dem Überwachungsbereich 14 reflektiert oder remittiert und als Empfangspuls 18 von dem Laserscanner 10 empfangen. Aus der Lichtlaufzeit zwischen Aussenden und Empfangen des Lichtpulses 12, 18 ermittelt der Laserscanner 10 den Abstand der Oberfläche 16.

Wie einleitend gesagt, kann alternativ zu einem Pulsverfahren auch ein Phasenverfahren eingesetzt werden. Die Erfindung wird aber im Weiteren am Beispiel von Pulsen beschrieben. Die allgemeine Funktionsweise eines Laserscanners 10 einschließlich dessen Scanmechanismus, etwa durch einen Drehspiegel realisiert, Optiken im Sende- und Empfangskanal und dergleichen ist bekannt, beispielsweise aus der DE 43 40 756 A1 oder der einleitend bereits genannten EP 1 936 400 A1, und wird hier nicht näher erläutert.

Der Empfangspuls 18 weist im Gegensatz zum Sendepuls 12 mehrere Peaks auf. Diese mehrfachen Peaks können durch nicht dargestellte teiltransparente Störungen im optischen Pfad zwischen Laserscanner 10 und Oberfläche 16 entstehen. Ursachen können beispielsweise Nebel- oder Regentropfen oder Glasflächen einschließlich einer Frontscheibe des Laserscanners 10 sein. Erfindungsgemäß ist in einer bevorzugten Ausführungsform vorgesehen, die Form des Empfangspulses 18 insgesamt auszuwerten, also innerhalb der Auswertung zu entscheiden, welcher Peak der tatsächliche Messempfangspuls von der Oberfläche 16 ist. Dazu wird der Verlauf des Empfangspulses 18 gesampelt und ausgewertet.

Figur 2 zeigt in einem Blockschaltbild den Empfangskanal des Laserscanners 10 gemäß einer Ausführungsform der Erfindung. Der Empfangspuls 18 wird von einem Lichtempfangselement 20, beispielsweise einer Photodiode, einer PIN-Diode (positive intrinsic negative diode), einer APD (Avalanche Photodiode) in ein elektrisches Signal beziehungsweise einen Photostrom umgewandelt. Das Lichtempfangselement 20 könnte alternativ auch als Vielzahl, etwa als Matrix oder Zeile photoempfindlicher Elemente ausgebildet sein.

Das Signal des Lichtempfangselements 20 wird anschließend in zwei Pfade verzweigt. In einem ersten Pfad wird es einem beispielhaft als Verzögerungsleitung 22 ausgebildeten Verzögerungselement zugeführt, welches die Weiterleitung um eine Verzögerungszeit von beispielsweise 10 ns verzögert. Anschließend wird das Empfangssignal in einem steuerbaren Verstärker 24 verstärkt. Bei dem Verstärker 24 kann es sich beispielsweise um einen spannungsgesteuerten Verstärker handeln. Alternativ kann der Verstärker 24 beispielsweise auch stromgesteuert, digital oder als Transimpedanzverstärker ausgebildet sein. Das derart verstärkte Signal wird dann in einem Analog/Digitalwandler 26 digitalisiert und schließlich in einer Auswertungseinheit 28 des Laserscanners 30 ausgewertet, indem die Pulslage festgestellt, daraus die Lichtlaufzeit und schließlich der dazu proportionale Abstand der Oberfläche 16 bestimmt wird.

In einem zweiten Pfad wird der Photostrom von dem Lichtempfangselement 20 hinsichtlich seiner Amplitude ausgewertet. Dazu ist in der dargestellten Ausführungsform ein Peakdetektor 30 vorgesehen, welcher also die Maximalamplitude des Empfangspulses bestimmt und diese als Steuerspannung einem Stellglied des spannungsgesteuerten Verstärkers 24 zuführt. Da die Pulse sehr kurz, beispielsweise 3 ns breit sind, und der Peakdetektor 30 die Maximalamplitude sehr schnell bestimmen kann, liegt eine der Maximalamplitude des Eingangspulses entsprechende Steuerspannung bereits an dem Verstärker 24 an, wenn auf dem ersten Pfad das verzögerte Empfangssignal einläuft. Die Verzögerungsleitung 22 stellt ausreichende Zeit für die Gainverstellung zur Verfügung, berücksichtigt also sowohl die Pulsbreite als auch die Lauf- und Verarbeitungszeit in dem zweiten Pfad. Der Verstärker 24 verstärkt deshalb das Eingangssignal mit einer bereits rechtzeitig an die Maximalamplitude angepassten Steuerung und kann so seinen linearen Bereich optimal ausnutzen.

Der Peakdetektor 30 sollte einen hohen Dynamikbereich verarbeiten können, wie dies beispielsweise durch eine logarithmische Kennlinie realisierbar ist. Die Auswertungseinheit 28, der Peakdetektor 30 selbst oder eine andere Komponente des Laserscanners 10 kann die Peakinformation mittels eines Triggers über einen Reseteingang 32 löschen. Dies kann auch durch Entladen eines Ladekondensators geschehen. Damit wird erreicht, dass bei mehreren aufeinanderfolgenden Empfangspeaks zu demselben oder aufeinanderfolgenden Sendepulsen 12 jeweils die für die Peakamplitude optimale Verstärkung eingestellt werden kann.

Alternativ zu einem Peakdetektor 30 können auch andere Elemente eingesetzt werden, welche Informationen über die Amplitude des Empfangspulses erzeugen, beispielsweise ein oder mehrere Schwellendetektoren. Damit kann statt einer optimalen Anpassung zumindest eine Verstärkungsklasse ausgewählt werden, wie beispielsweise ein schwacher, mittlerer oder starker Gainfaktor.

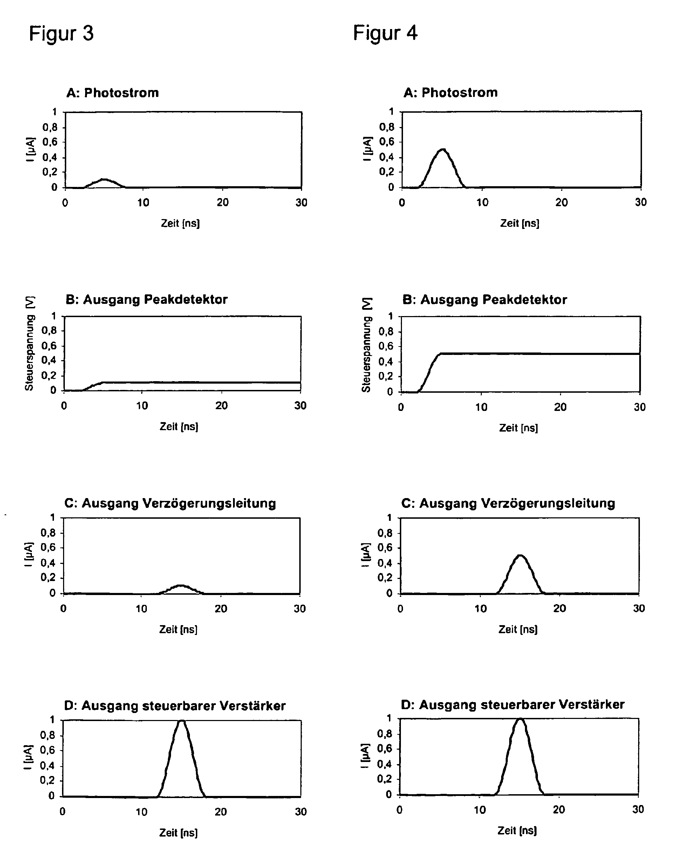

Figur 3 und 4 zeigen den Pulsverlauf an verschiedenen in der Figur 2 bezeichneten Stellen innerhalb des Empfangspfades des Laserscanners 10. Dabei unterscheiden sich Figur 3 und 4 darin voneinander, dass in Figur 3 ein schwächerer Photostrom von 0,1 µA und in Figur 4 ein stärkerer Photostrom von 0,5 µA gewählt wurde. Die Verzögerungszeit der Verzögerungsleitung 22 beträgt jeweils 10 ns. Alle Zahlenwerte sind beispielhaft und dienen nur der Illustration des Prinzips.

In den Figuren 3A und 4A ist der Photostrom des Lichtempfangselements 20 bei Position A in Figur 2 über die Zeit dargestellt. Zur Illustration der optimal angepassten Verstärkungswirkung ist jeweils ein Puls mit einer beispielhaften Breite 3ns, aber deutlich unterschiedlicher Maximalamplitude gezeigt.

In den Figuren 3B und 4B ist die Ausgangsspannung des Peakdetektors 30 bei Position B in Figur 2 über die Zeit dargestellt. Diese Ausgangsspannung steigt mit der steigenden Flanke der Empfangspulse an und bleibt dann auf dem Plateau der erreichten Maximalamplitude. Deshalb ist der Reseteingang 32 vorgesehen, um die Amplitudeninformation für den nächsten, möglicherweise schwächeren Empfangspuls zu löschen.

Die Figuren 3C und 4C zeigen den mittels der Verzögerungsleitung 22 um 10 ns verzögerten Photostrom bei Position C in Figur 2. Wie leicht zu erkennen ist, hat der Peakdetektor bei der steigenden Flanke der verzögerten Photoströme bereits sein Maximum erreicht. Die Ausgangsspannung des Peakdetektors 30 wird als Steuerspannung an das Stellglied des steuerbaren Verstärkers 24 gelegt, so dass der Verstärker 24 bereits auf die Amplitude des Empfangssignals eingestellt ist, wenn der verzögerte Peak den Verstärker 24 erreicht. Dabei ist die Kennlinie des Stellglieds so gewählt, dass die Maximalamplitude des eingehenden Empfangssignals auf eine vorgegebene, den Verstärker bevorzugt möglichst vollständig ausnutzende Amplitude des verstärkten Empfangssignals abgebildet wird.

Aufgrund der rechtzeitigen Aussteuerung des Verstärkers 24 haben die in den Figuren 3D und 4D gezeigten Ausgangssignale des Verstärkers 24 an Position D der Figur 2 die gleiche Maximalamplitude. Die Pulsform selbst kann je nach Unterschieden in den Lichtverhältnissen oder im Remissionsverhalten entgegen der vereinfachten Darstellung noch abweichen.

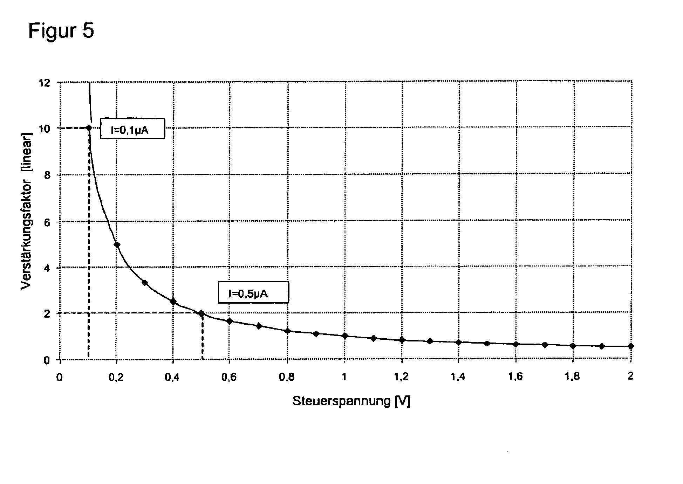

Figur 5 zeigt ein Beispiel einer Kennlinie des Stellglieds des Verstärkers 24. Diese Kennlinie ist so abgestimmt, dass am Ausgang des Stellglieds für alle Eingangspulse eine zumindest annähernd konstante und bevorzugt maximale Amplitude gegeben ist. Mit gestrichelten Linien sind die Verstärkungsfaktoren beziehungsweise Gains für die in den Figuren 3 und 4 gezeigten beispielhaften Photoströme von 0,1 µA und 0,5 µA illustriert.

## Patentansprüche

1. Entfernungsmessender pulsbasierter Laserscanner (10) mit einer Laserlichtquelle zum Aussenden eines Lichtsignals (12), einem Lichtempfangselement (20) zum Empfang eines Empfangssignals (18), einer Auswertungseinheit (28), die für die Ermittlung von Entfernungen aus einer Laufzeit des Lichtsignals (12) ausgebildet ist, sowie mit einem steuerbaren Verstärker (24) für das Empfangssignal (18), wobei ein Amplituden-Bestimmungselement (30) vorgesehen ist, welches eine Amplitudeninformation von Empfangssignalen bestimmen kann und wobei der Verstärker (24) auf Basis einer Amplitudeninformation des zu verstärkenden Empfangssignals selbst steuerbar ist,
**dadurch gekennzeichnet,**
**dass** die Auswertungseinheit (28) dafür ausgebildet ist, mehrere Peaks des Empfangssignals auszuwerten, die aus demselben Sendepuls resultieren, und für jeden Peak erneut eine Amplitudeninformation zu gewinnen und den Verstärker (24) entsprechend zu steuern, so dass jeder Peak des Empfangssignals optimal verstärkt wird.

2. Laserscanner (10) nach Anspruch 1,
wobei das Lichtempfangselement (20) über ein Verzögerungselement (22) mit dem Verstärker (24) verbunden ist, wobei die Verbindung mit dem Verzögerungselement (22) dafür ausgebildet ist, das Empfangssignal so weit verzögert dem Verstärker (24) zuzuführen, dass der Verstärker (24) aufgrund der Amplitudeninformation gesteuert ist, ehe das Empfangssignal den Verstärker (24) erreicht.

3. Laserscanner (10) nach Anspruch 2,
wobei das Verzögerungselement als Verzögerungsleitung (22) ausgebildet ist, deren Länge auf die Verarbeitungszeit des Amplituden-Bestimmungselements (30) und/oder die Verarbeitungszeit für die Steuerung des Verstärkers (24) abgestimmt ist.

4. Laserscanner (10) nach einem der vorhergehenden Ansprüche,
wobei das Amplituden-Bestimmungselement (30) die Amplitudeninformation anhand einer oder mehrerer Schwellen bestimmt, oder wobei das Amplituden-Bestimmungselement ein Peakdetektor (30) ist.

5. Laserscanner (10) nach einem der vorhergehenden Ansprüche,
wobei das Amplituden-Bestimmungselement (30) mit einem Stellglied des Verstärkers (24) verbunden ist und eine Steuerspannung, einen Steuerstrom oder einen digitalen Verstärkungsfaktor an das Stellglied übertragen kann.

6. Laserscanner (10) nach einem der vorhergehenden Ansprüche,
wobei das Amplituden-Bestimmungselement (30) eine Resettriggerquelle, insbesondere einen Reseteingang (32) aufweist, und wobei insbesondere die Auswertungseinheit (28) oder eine Teilkomponente des Amplituden-Bestimmungselements (30) dafür ausgebildet ist, das Amplituden-Bestimmungselement (30) über die Resettriggerquelle zurückzusetzen.

7. Laserscanner (10) nach einem der vorhergehenden Ansprüche,
wobei das Amplituden-Bestimmungselement (30) eine Kennlinie aufweist, welche eine hohe Dynamik abbilden kann, insbesondere eine logarithmische Kennlinie, und wobei die Kennlinie des Stellglieds so abgestimmt ist, dass Empfangssignale beliebiger Eingangsstärke von dem Verstärker (24) auf verstärkte Empfangssignale zumindest annähernd gleicher Peakamplitude abgebildet werden.

8. Verfahren zur Erfassung von Entfernungen mittels eines pulsbasierten Laserscanners (10) anhand einer Lichtlaufzeit zwischen Aussenden eines Lichtsignals (12) und Empfangen eines Empfangssignals (18), wobei das Empfangssignal (18) in einem steuerbaren Verstärker (24) verstärkt wird und der Verstärker (24) anhand einer jeweils aus dem zu verstärkenden Empfangssignal gewonnenen Amplitudeninformation gesteuert wird,
**dadurch gekennzeichnet,**
**dass** mehrere Peaks des Empfangssignals ausgewertet werden, die aus demselben Sendepuls resultieren, und dass für jeden Peak innerhalb desselben Empfangssignals infolge desselben Sendepulses erneut eine Amplitudeninformation gewonnen und der Verstärker (24) entsprechend gesteuert wird, so dass jeder Peak des Empfangssignals optimal verstärkt wird.

9. Verfahren nach Anspruch 8,
wobei das Empfangssignal so lange verzögert wird, dass es den Verstärker (24) erst erreicht, wenn der Verstärker (24) aufgrund der Amplitudeninformation gesteuert ist.

10. Verfahren nach Anspruch 9,
wobei das Empfangssignal um die Verarbeitungszeit für die Gewinnung der Amplitudeninformation und/oder für das Steuern des Verstärkers (24) verzögert wird, insbesondere durch Weiterleiten auf einer Verzögerungsleitung (22).

11. Verfahren nach einem der Ansprüche 8 bis 10,
wobei die Amplitudeninformation anhand einer oder mehrerer Schwellenoperationen bestimmt wird, oder wobei die Peakamplitude des Empfangssignals bestimmt wird.

12. Verfahren nach einem der Ansprüche 8 bis 11,
wobei eine von der Amplitudeninformation abgeleitete Größe an ein Stellglied des Verstärkers (24) weitergeleitet wird, insbesondere eine Steuerspannung, ein Steuerstrom oder ein digitaler Verstärkungsfaktor.

13. Verfahren nach einem der Ansprüche 8 bis 12,
wobei die Amplitudeninformation nach jedem verstärkten Empfangssignal, insbesondere nach jedem verstärkten Peak eines Empfangssignals zurückgesetzt wird.

14. Verfahren nach einem der Ansprüche 8 bis 13,
wobei die Kennlinie für die Gewinnung der Amplitudeninformation so abgestimmt wird, dass sie eine hohe Dynamik abbilden kann, insbesondere logarithmisch ist.

15. Verfahren nach einem der Ansprüche 8 bis 14,
wobei die Kennlinie des Stellglieds so abgestimmt wird, dass Empfangssignale beliebiger Eingangsstärke von dem Verstärker (24) auf verstärkte Empfangssignale zumindest annähernd gleicher Peakamplitude abgebildet werden.

## Claims

1. A distance-measuring pulse-based laser scanner (10) having a laser light source for transmitting a light signal (12), having a light reception element (20) for receiving a received signal (18), having an evaluation unit (28) which is designed for the determination of distances from a time of flight of the light signal (12) as well as having a variable gain amplifier (24) for the received signal (18), wherein an amplitude determination element (30) is provided which can determine amplitude information from received signals, and wherein the amplifier (24) is controllable on the basis of amplitude information of the received signal to be amplified itself,
**characterized in that**
the evaluation unit (28) is designed to evaluate a plurality of peaks of the received signal which result from the same transmitted pulse and again to acquire amplitude information for each peak and to control the amplifier (24) accordingly so that each peak of the received signal is ideally amplified.

2. A laser scanner (10) in accordance with claim 1,
wherein the light reception element (20) is connected to the amplifier (24) via a delay element (22), wherein the connection to the delay element (22) is designed to supply the received signal to the amplifier (24) with so much delay that the amplifier (24) is controlled on the basis of the amplitude information before the received signal reaches the amplifier (24).

3. A laser scanner (10) in accordance with claim 2,
wherein the delay element is designed as a delay line (22) whose length is matched to the processing time of the amplitude determination element (30) and/or to the processing time for the control of the amplifier (24).

4. A laser scanner (10) in accordance with any one of the preceding claims,
wherein the amplitude determination element (30) determines the amplitude information with reference to one or more thresholds, or wherein the amplitude determination element is a peak detector (30).

5. A laser scanner (10) in accordance with any one of the preceding claims,
wherein the amplitude determination element (30) is connected to an actuator of the amplifier (24) and can transfer a control voltage, a control current or a digital gain factor to the actuator.

6. A laser scanner (10) in accordance with any one of the preceding claims,
wherein the amplitude determination element (30) has a retriggering source, in particular a reset input (32), and wherein in particular the evaluation unit (28) or a part component of the amplitude determination element (30) is designed to reset the amplitude determination element (30) via the retriggering source.

7. A laser scanner (10) in accordance with any one of the preceding claims,
wherein the amplitude determination element (30) has a characteristic line which can map high dynamics, in particular a logarithmic characteristic line, and wherein the characteristic line of the actuator is matched such that received signals of any desired input strength are mapped by the amplifier (24) to amplified received signals of at least approximately the same peak amplitude.

8. A method of detecting distances by means of a pulse-based laser scanner (10) with reference to a time of flight between the transmission of a light signal (12) and the reception of a received signal (18), wherein the received signal (18) is amplified in a variable gain amplifier (24) and the amplifier (24) is controlled with reference to respective amplitude information acquired from the received signal to be amplified,
**characterized in that**
a plurality of peaks of the received signal are evaluated which result from the same transmitted pulse; and **in that** amplitude information is again acquired for each peak within the same received signal as a consequence of the same transmitted pulse and the amplifier (24) is controlled accordingly so that each peak of the received signal is ideally amplified.

9. A method in accordance with claim 8,
wherein the received signal is delayed for so long that it only reaches the amplifier (24) when the amplifier (24) is controlled on the basis of the amplitude information.

10. A method in accordance with claim 9,
wherein the received signal is delayed by the processing time for the acquisition of the amplitude information and/or for the control of the amplifier (24), in particular by forwarding to a delay line (22).

11. A method in accordance with any one of the claims 8 to 10,
wherein the amplitude information is determined with reference to one or more threshold operations, or wherein the peak amplitude of the received signal is determined.

12. A method in accordance with any one of the claims 8 to 11,
wherein a value derived from the amplitude information is forwarded to an actuator of the amplifier (24), in particular a control voltage, a control current or a digital gain factor.

13. A method in accordance with any one of the claims 8 to 12,
wherein the amplitude information is reset after each amplified received signal, in particular after each amplified peak of a received signal.

14. A method in accordance with any one of the claims 8 to 13,
wherein the characteristic line for the acquisition of the amplitude information is matched so that it can map high dynamics, in particular logarithmically.

15. A method in accordance with any one of the claims 8 to 14,
wherein the characteristic line of the actuator is matched so that received signals of any desired received strength are mapped by the amplifier (24) onto amplified received signals of at least approximately the same peak amplitude.

## Revendications

1. Scanneur à laser (10) mesurant des éloignements en se basant sur des impulsions, comprenant une source de lumière laser pour émettre un signal lumineux (12), un élément récepteur de lumière (20) pour recevoir un signal reçu (18), une unité d'évaluation (28) qui est réalisée pour déterminer des éloignements à partir d'un temps de parcours du signal lumineux (12), et comprenant un amplificateur à commander (24) pour le signal reçu (18), dans lequel il est prévu un élément de détermination d'amplitude (30) qui est capable de déterminer une information d'amplitude de signaux reçus, et dans lequel l'amplificateur (24) est susceptible d'être commandé en se basant sur des informations d'amplitude du signal reçu amplifié lui-même,
**caractérisé en ce que**
l'unité d'évaluation (28) est réalisée pour évaluer plusieurs pics du signal reçu qui résultent de la même impulsion émise, et pour récupérer pour chaque pic à nouveau une information d'amplitude et commander de façon correspondante l'amplificateur (24) de telle façon que chaque pic du signal reçu est amplifié de façon optimale.

2. Scanneur à laser (10) selon la revendication 1,
dans lequel l'élément récepteur de lumière (20) est relié à l'amplificateur (24) via un élément à retard (22), et la liaison avec l'élément à retard (22) est réalisée pour amener le signal reçu à l'amplificateur (24) avec un retard tel que l'amplificateur (24) est commandé en raison de l'information d'amplitude avant que le signal reçu atteigne l'amplificateur (24).

3. Scanneur à laser (10) selon la revendication 2,
dans lequel l'élément à retard est réalisé sous forme de ligne à retard (22) dont la longueur est accordée au temps de traitement de l'élément de détermination d'amplitude (30) et/ou au temps de traitement pour la commande de l'amplificateur (24).

4. Scanneur à laser (10) selon l'une des revendications précédentes,
dans lequel l'élément de détermination d'amplitude (30) détermine les informations d'amplitude au moyen d'un ou plusieurs seuils, ou dans lequel l'élément de détermination d'amplitude est un détecteur de pic (30).

5. Scanneur à laser (10) selon l'une des revendications précédentes,
dans lequel l'élément de détermination d'amplitude (30) est relié à un élément de réglage de l'amplificateur (24), et est capable de transmettre à l'élément de réglage une tension de commande, un courant de commande ou un facteur d'amplification numérique.

6. Scanneur à laser (10) selon l'une des revendications précédentes,
dans lequel l'élément de détermination d'amplitude (30) comprend une source de déclenchement de remise à zéro, en particulier une entrée de remise à zéro (32), et dans lequel en particulier l'unité d'évaluation (28) ou une composante partielle de l'élément de détermination d'amplitude (30) est réalisée pour remettre à zéro l'élément de détermination d'amplitude (30) via la source de déclenchement de remise à zéro.

7. Scanneur à laser (10) selon l'une des revendications précédentes,
dans lequel l'élément de détermination d'amplitude (30) comporte une courbe caractéristique qui est capable de présenter une forte dynamique, en particulier une courbe caractéristique logarithmique, et dans lequel la courbe caractéristique de l'élément de réglage est accordée de telle façon que des signaux reçus avec une intensité d'entrée quelconque sont reproduits par l'amplificateur (24) sur des signaux reçus amplifiés présentant au moins approximativement la même amplitude de pic.

8. Procédé pour déterminer des éloignements au moyen d'un scanneur à laser (10) basé sur des impulsions, au moyen d'un temps de parcours de la lumière entre l'émission d'un signal lumineux (12) et la réception d'un signal reçu (18), dans lequel le signal reçu (18) est amplifié dans un amplificateur à commander (24) et l'amplificateur (24) est commandé au moyen d'une information d'amplitude récupérée à partir du signal reçu à amplifier,
**caractérisé en ce que**
on évalue plusieurs pics du signal reçu, qui résultent de la même impulsion émise, et **en ce que** l'on récupère, pour chaque pic à l'intérieur du même signal reçu qui succède la même impulsion émise, à nouveau une information d'amplitude, et l'amplificateur (24) est commandé de façon correspondante, de telle façon que chaque pic du signal reçu est amplifié de façon optimale.

9. Procédé selon la revendication 8,
dans lequel le signal reçu est retardé aussi longtemps qu'il atteigne l'amplificateur (24) uniquement quand l'amplificateur (24) est commandé en se basant sur les informations d'amplitude.

10. Procédé selon la revendication 9,
dans lequel le signal reçu est retardé du temps de traitement pour la récupération des informations d'amplitude, et/ou pour la commande de l'amplificateur (24), en particulier par transmission sur une ligne à retard (22).

11. Procédé selon l'une des revendications 8 à 10,
dans lequel les informations d'amplitude sont déterminées au moyen d'une ou plusieurs opérations à seuil, ou dans lequel l'amplitude de pic du signal reçu est déterminée.

12. Procédé selon l'une des revendications 8 à 11,
dans lequel on transmet à un élément de réglage de l'amplificateur (24) une grandeur dérivée des informations d'amplitude, en particulier une tension de commande, un courant de commande ou un facteur d'amplification numérique.

13. Procédé selon l'une des revendications 8 à 12,
dans lequel les informations d'amplitude sont remises à zéro après chaque signal reçu amplifié, en particulier après chaque pic amplifié d'un signal reçu.

14. Procédé selon l'une des revendications 8 à 13,
dans lequel la ligne caractéristique pour la récupération des informations d'amplitude est accordée de telle façon qu'elle peut représenter une haute dynamique, en particulier qu'elle est logarithmique.

15. Procédé selon l'une des revendications 8 à 14,
dans lequel la ligne caractéristique de l'élément de réglage est accordée de telle façon que des signaux reçus avec une intensité d'entrée quelconque sont représentés sur des signaux reçus amplifiés ayant au moins approximativement la même amplitude de pic.
